# FASCICULE DE BREVET EUROPEEN

(11) **EP 1 164 379 B1**
(45) Date de publication et mention de la délivrance du brevet: **01.12.2004**
(21) Numéro de dépôt: 01401518.4
(22) Date de dépôt: 12.06.2001
(51) Int. Cl.: G01R 1/067

(54) **Contrôleur notamment de tension pour prise électrique et boîtier-support pour un tel contrôleur**
Spannungstester für elektrische Steckdose und Steckdose für selbigen
Voltage tester for electric socket and housing for the same

(30) Priorité: 14.06.2000 FR 0007567
(43) Date de publication de la demande: 19.12.2001
(73) Titulaire: Société Anonyme des Etablissements CATU, 92220 Bagneux (FR)
(72) Inventeur: Arberet, Sylvestre, 92260 Fontenay Aux Roses (FR)
(74) Mandataire: Santarelli

(56) Documents cités:
- US-A- 4 259 635
- US-A- 4 721 903

## Description

La présente invention concerne un contrôleur électrique notamment de tension, plus particulièrement un contrôleur comportant un boîtier-support et deux testeurs à pointe de touche.

On connaît déjà par US-A-4,259,635 un contrôleur électrique dont l'un des testeurs, dit à câble, est relié au boîtier-support par un câble, l'autre testeur étant rigidement lié au boîtier-support.

Le test d'un appareil ou d'un circuit est réalisé en mettant en oeuvre les pointes de touche des testeurs. Lorsque le testeur à câble est engagé dans une rainure latérale du boîtier-support, la distance entre les deux pointes de touche correspond à celle qui sépare les axes des alvéoles d'une prise de courant de sorte que le test d'une prise de courant peut être réalisé d'une seule main.

La présente invention a pour but de proposer un contrôleur du type ci-dessus, permettant le test d'une prise de courant de manière simple, rapide et d'une seule main, dont la coopération entre le boîtier-support et les testeurs est avantageuse.

L'invention propose un contrôleur électrique notamment de tension comportant un boîtier-support et deux testeurs à pointe de touche dont l'un, dit à câble, est relié au boîtier-support par un câble, avec le boîtier-support qui est adapté à porter latéralement ledit testeur à câble et à porter les deux testeurs dans une position de test dans laquelle les deux pointes de touche s'étendent globalement parallèles l'une à l'autre en étant à une distance correspondant à celle qui sépare les axes des alvéoles d'une prise de courant, caractérisé par le fait que le boîtier-support est adapté à porter latéralement les deux testeurs, lesquels sont du type à câble, reliés chacun au boîtier-support par un câble, chaque testeur à câble présentant un corps globalement cylindrique adapté à être supporté par le boîtier-support entre l'une de ses faces, dite face arrière, et au moins une aile s'étendant latéralement depuis une nervure centrale dont il est muni, le corps globalement cylindrique de chaque testeur à câble étant muni d'une collerette adaptée à prendre place dans une rainure dite de test ménagée dans la face arrière du boîtier-support pour le positionnement axial en position de test de ce testeur à câble, et adaptée à prendre place dans une rainure dite de rangement, distincte de la rainure de test, ménagée dans la face arrière du boîtier-support pour le positionnement axial en position de rangement de ce testeur à câble.

De préférence, le boîtier-support est muni de deux ailes qui s'étendent depuis la nervure centrale, l'une d'extrémité, l'autre centrale.

Selon un mode préféré, le boîtier-support est muni de deux ailes s'étendant latéralement de part et d'autre de la nervure centrale ; le boîtier-support est muni de deux paires d'ailes, une paire d'ailes d'extrémité et une paire d'ailes centrales, les ailes d'une même paire s'étendant latéralement de part et d'autre de la nervure centrale.

De préférence, les testeurs comportent des fourreaux de protection pour protéger les pointes de touche.

Avantageusement, les fourreaux de protection sont montés mobiles, à l'encontre de moyens élastiques de rappel, entre une position déployée de repos, pour laquelle ils s'étendent au delà de l'extrémité des pointes de touche et une position rétractée, de service, pour laquelle ils dégagent au moins partiellement les pointes de touche.

De préférence, la position déployée de repos des fourreaux de protection est verrouillable sous le contrôle d'un organe de déverrouillage propre à permettre leur libération.

Avantageusement, l'organe de déverrouillage est mis en oeuvre lors de la préhension du boîtier-support, le testeur à câble étant porté par le boîtier-support dans sa position de test.

Selon une forme préférée de réalisation, l'organe de déverrouillage est un levier ; en variante, c'est un bouton-poussoir.

La présente invention a également pour objet un boîtier-support pour contrôleur électrique ayant les caractéristiques du boîtier-support du contrôleur ci-dessus.

Pour mieux faire comprendre l'objet de l'invention, on va en décrire maintenant, à titre d'exemple, purement illustratif et non limitatif, un mode de réalisation représenté sur les dessins annexés.

Sur ces dessins :
- la figure 1 est une vue en plan d'un contrôleur selon l'invention comportant deux testeurs à câble ;
- la figure 2 est une vue de dessous du boîtier-support du contrôleur de la figure 1 ;
- la figure 3 est une vue de dessous du contrôleur de la figure 1 montrant ses deux testeurs en position de rangement ; - la figure 4 est une vue de dessous du contrôleur de la figure 1 montrant ses deux testeurs en position de test.

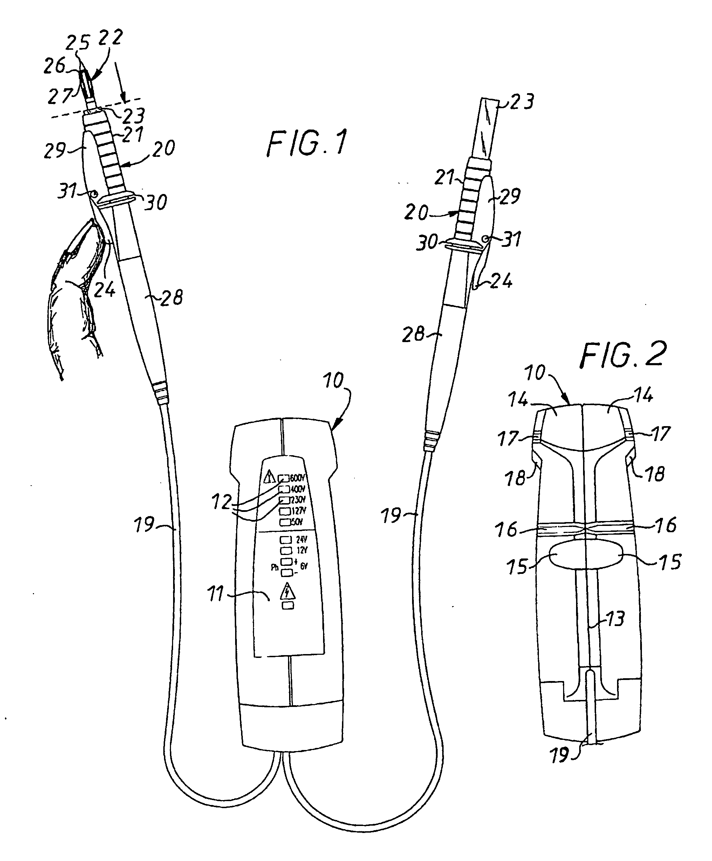

En se reportant aux figures, on voit un contrôleur notamment de tension comportant un boîtier-support 10 dont la face avant 11, figure 1, présente des voyants 12 de contrôle ; à titre d'exemple, le contrôleur est un vérificateur d'absence de tension alternative ou continue ; il permet en plus de contrôler les niveaux de tension de 6 à 600 volts et la continuité d'un circuit électrique hors tension, de rechercher la phase en tension alternative, de déterminer les polarités en tension continue.

Pour cela, le contrôleur comporte deux testeurs 20 à pointes de touche 22 ; ici, les deux testeurs 20 sont du type "sur fil", étant reliés par des câbles 19 au boîtier-support 10.

Chaque testeur 20 comporte, portée par un corps 21 en matière isolante, une pointe de touche 22 propre à permettre l'établissement d'un contact, avec, entourant cette pointe de touche 22, un fourreau de protection 23 qui, à l'encontre de moyens élastiques de rappel, est monté mobile entre une position déployée de repos, partie supérieure droite de la figure 1, pour laquelle il s'étend au delà de l'extrémité 25 de la pointe de touche 22, et une position rétractée de service, partie supérieure gauche de la figure 1, pour laquelle il dégage au moins partiellement celle-ci.

Dans la forme de réalisation représentée, l'extrémité, ainsi susceptible d'être dégagée, de la pointe de touche 22, est propre à permettre un contact frontal, soit en bout, à sa propre extrémité 25, soit intermédiaire, à la faveur d'un épaulement globalement tronconique 26 légèrement en retrait par rapport à cette extrémité 25, et présentant en outre, entre deux épaulements, dans cette forme de réalisation, également en retrait par rapport à l'épaulement globalement tronconique 26 précédent, une cage élastiquement déformable radialement 27 propre à permettre un contact latéral.

Ces dispositions étant bien connues par elles-mêmes, elles ne seront pas décrites plus en détail ici.

A son autre extrémité, la pointe de touche 22 est en liaison électrique avec l'âme conductrice du câble 19 et sur l'ensemble est surmoulé un manchon 28 en matière isolante.

Le fourreau de protection 23, qui est monté coulissant dans le nez tubulaire du corps 21 en matière isolante, est verrouillable en position déployée de repos sous le contrôle d'un organe de déverrouillage 24 qui est à la disposition de l'usager et propre à en permettre la libération.

Ici, l'organe de déverrouillage 24 se présente sous la forme d'un levier monté articulé autour d'un axe 31 porté par des ailes longitudinales 29 que comporte le corps 21 du testeur 20.

Ainsi, il suffit d'appuyer latéralement sur le levier 24, comme illustré figure 1, pour déverrouiller le fourreau de protection 23.

Le boîtier-support 10 est adapté à recevoir et supporter le testeur 20.

Pour ce faire, le boîtier-support 10 présente sur sa face arrière, visible sur la figure 2, une nervure centrale 13 d'où partent latéralement, de part et d'autre, des ailes de retenue, à savoir ici deux ailes d'extrémité 14, placées en bout du boîtier-support 10, et deux ailes centrales 15, placées globalement dans la région centrale du boîtier-support 10 ; les ailes 14 et 15 sont à une distance de la face arrière du boîtier-support 10 telle que le testeur 20 peut être élastiquement inséré dans l'espace ainsi défini en s'étendant le long du boîtier-support 1.

Le corps 21 du testeur 20 étant muni d'une collerette 30 de protection, servant de garde-main, on profite de celle-ci pour assurer le positionnement axial du testeur 20 par rapport au boîtier-support 10.

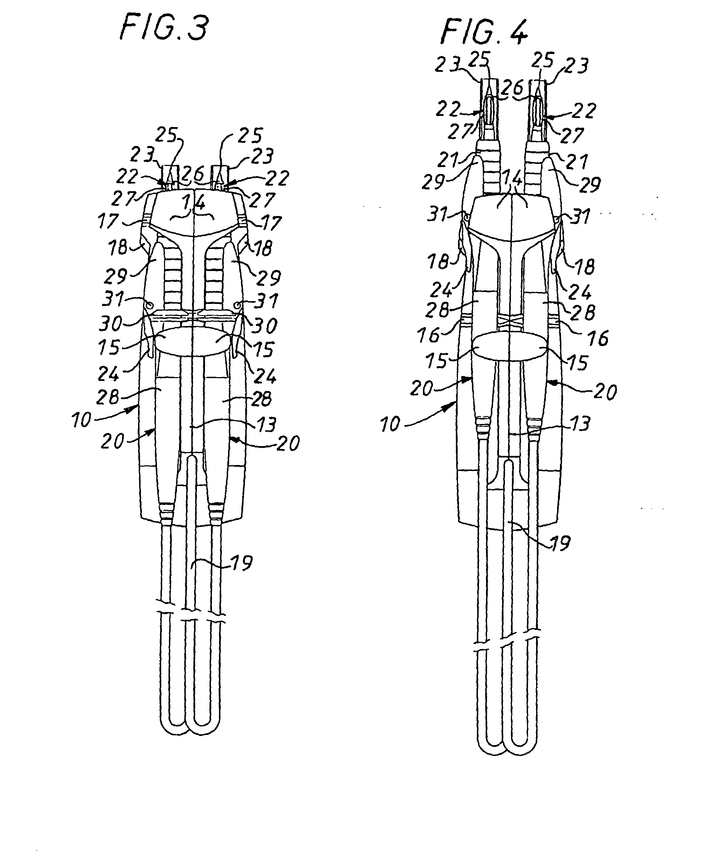

A cet effet, le boîtier-support 10 comporte, dans sa face arrière, une rainure 16 dite de rangement, placée ici entre les ailes 14 d'extrémité et 15 centrale, près de cette dernière, dans laquelle prend place la collerette de protection 30 pour le rangement du testeur 20 sur le boîtier-support 10, comme montré figure 3.

Une rainure 17 dite de test, ménagée dans la face arrière du boîtier-support 10, au droit de l'aile d'extrémité 14, permet de placer le testeur 20 dans une position de test ; dans cette position, un décrochement 18 latéral du boîtier-support 10 permet d'accéder latéralement au levier 24 de déverrouillage, comme visible figure 4 ; ce décrochement 18 a par ailleurs un rôle de garde-main.

Ici, le contrôleur comporte deux testeurs 20 à câble et le boîtier-support 10 est symétrique par rapport à un plan transversal traversant centralement sa nervure centrale 13 ; ainsi, lorsque les deux testeurs 20 sont en position de test, figure 4, leurs pointes de touche 22 sont globalement parallèles l'une à l'autre en étant à une distance correspondant à celle qui sépare les axes des alvéoles d'une prise de courant, par exemple égale à 19 millimètres ; il suffit, pour tester une telle prise de courant, de prendre en main le boîtier-support 10, le pouce et l'index appliqués sur les leviers 24, et de présenter les pointes de touche 22 dans ladite prise : un tel test est simple, rapide et effectué d'une seule main, même si la prise de courant est équipée d'obturateurs de protection pour éviter l'introduction accidentelle d'objets

Selon une variante non représentée, le testeur est du type de celui décrit dans le document EP-A-0 337 875 ; selon cette variante, l'organe de déverrouillage est lié axialement au fourreau de protection et se présente sous la forme d'un bouton-poussoir en saillie sur la surface extérieure du corps du testeur ; plus précisément, l'organe de déverrouillage est relié au fourreau de protection par une languette élastiquement déformable qui, à distance de son raccordement audit fourreau de protection, présente un cran par lequel elle est propre à coopérer en verrouillage débrayable avec un cran prévu à cet effet sur le corps du testeur ; une action d'enfoncement sur l'organe de déverrouillage libère le cran de la languette.

## Revendications

1. Contrôleur électrique notamment de tension comportant un boîtier-support (10) et deux testeurs (20) à pointe de touche (22) dont le boîtier-support (10) est adapté à porter les deux testeurs (20) dans une position de test dans laquelle les deux pointes de touche (22) s'étendent globalement parallèles l'une à l'autre en étant à une distance correspondant à celle qui sépare les axes des alvéoles d'une prise de courant, **caractérisé par le fait que** le boîtier-support (10) est adapté à porter latéralement les deux testeurs (20), lesquels sont du type à câble, reliés chacun au boîtier-support (10) par un câble (19), chaque testeur (20) à câble présentant un corps (21) globalement cylindrique adapté à être supporté par le boîtier-support (10) entre l'une de ses faces, dite face arrière et au moins une aile (14, 15) s'étendant latéralement depuis une nervure centrale (13) dont il est muni, le corps (21) globalement cylindrique de chaque testeur (20) à câble étant muni d'une collerette (30) adaptée à prendre place dans une rainure (17) dite de test ménagée dans la face arrière du boîtier-support (10) pour le positionnement axial en position de test de ce testeur (20) à câble, et adaptée à prendre place dans une rainure (16) dite de rangement, distincte de la rainure de test (17), ménagée dans la face arrière du boîtier-support (10) pour le positionnement axial en position de rangement de ce testeur à câble (20).

2. Contrôleur selon la revendication 1, **caractérisé par le fait que** le boîtier-support (10) est muni de deux ailes (14, 15) qui s'étendent depuis la nervure centrale (13), l'une (14) d'extrémité, l'autre (15) centrale.

3. Contrôleur selon l'une des revendications 1 ou 2, **caractérisé par le fait que** le boîtier-support (10) est muni de deux ailes (14, 15) s'étendant latéralement de part et d'autre de la nervure centrale (13).

4. Contrôleur selon la revendication 3, **caractérisé par le fait que** le boîtier-support (10) est muni de deux paires d'ailes (14, 15), une paire d'ailes (14) d'extrémité et une paire d'ailes (15) centrales, les ailes (14, 15) d'une même paire s'étendant latéralement de part et d'autre de la nervure centrale (13).

5. Contrôleur selon l'une des revendications 1 à 4, **caractérisé par le fait que** les testeurs (20) comportent des fourreaux de protection (23) pour protéger les pointes de touche (22).

6. Contrôleur selon la revendication 5, **caractérisé par le fait que** les fourreaux de protection (23) sont montés mobiles, à l'encontre de moyens élastiques de rappel, entre une position déployée de repos, pour laquelle ils s'étendent au delà de l'extrémité des pointes de touche (22) et une position rétractée, de service, pour laquelle ils dégagent au moins partiellement les pointes de touche (22).

7. Contrôleur selon la revendication 6, **caractérisé par le fait que** la position déployée de repos des fourreaux de protection (23) est verrouillable sous le contrôle d'un organe de déverrouillage (24) propre à permettre leur libération.

8. Contrôleur selon la revendication 7, **caractérisé par le fait que** l'organe de déverrouillage (24) est mis en oeuvre lors de la préhension du boîtier-support (10), le testeur à câble (20) étant porté par le boîtier-support (10) dans sa position de test.

9. Contrôleur selon l'une des revendications 7 ou 8, **caractérisé par le fait que** l'organe de déverrouillage (24) est un levier.

10. Contrôleur selon l'une des revendications 7 ou 8, **caractérisé par le fait que** l'organe de déverrouillage est un bouton-poussoir.

11. Boîtier-support pour contrôleur électrique, **caractérisé par le fait qu'**il a les caractéristiques du boîtier-support (10) du contrôleur selon l'une des revendications 1 à 10.

## Claims

1. Electrical tester, such as voltage tester, comprising two test probes (20) with test tips (22) and a casing (10) adapted to carry the two test probes (20) in a test position in which the two test tips (22) are generally parallel to each other at a distance corresponding to that between the axes of the receptacles of a socket outlet, **characterized in that** the casing (10) is adapted to carry laterally the two test probes (20), which are of the lead type, with each connected to the casing (10) by a respective lead (19), each test probe (20) has a generally cylindrical body (21) adapted to be supported by the casing (10) between one of its faces, called the rear face, and at least one flange (14, 15) extending laterally from a central rib (13) with which it is provided, and the generally cylindrical body (21) of each test probe (20) comprises a flange (30) adapted to fit into a test groove (17) in the rear face of the casing (10) for axially positioning the test probe (20) in a test position and to fit into a storage groove (16) in the rear face of the casing (10) and separate from the test groove (17) for axially positioning the test probe (20) in a storage position.

2. Tester according to claim 1, **characterized in that** the casing (10) comprises two flanges (14, 15) that extend from the central rib (13), one being an end flange (14) and the other a central flange (15).

3. Tester according to either claim 1 or claim 2, **characterized in that** the casing (10) comprises two flanges (14, 15) extending laterally from respective opposite sides of the central rib (13).

4. Tester according to claim 3, **characterized in that** the casing (10) comprises two pairs of flanges (14, 15), one being a pair of end flanges (14) and the other a pair of central flanges (15) and the flanges (14, 15) of the same pair extend laterally on respective opposite sides of the central rib (13).

5. Tester according to any of claims 1 to 4, **characterized in that** the test probes (20) comprise protective sleeves (23) for protecting the test tips (22).

6. Tester according to claim 5, **characterized in that** the protective sleeves (23) are mounted so that they are mobile against return spring means between a resting deployed position in which they extend beyond the ends of the test tips (22) and a retracted service position in which they at least partially expose the test tips (22).

7. Tester according to claim 6, **characterized in that** the sleeves (23) may be locked in the resting deployed position by a locking member (24) adapted to release them.

8. Tester according to claim 7, **characterized in that** the unlocking member (24) is operated by holding the casing (10) with the test probes (20) carried by the casing (10) in its test position.

9. Tester according to either claim 7 or claim 8, **characterized in that** the unlocking member (24) is a lever.

10. Tester according to either claim 7 or claim 8, **characterized in that** the unlocking member is a pushbutton.

11. Casing for an electrical tester, **characterized in that** it has the features of the casing (10) of the tester according to any of claims 1 to 10.

## Patentansprüche

1. Elektrischer Tester, insbesondere Spannungstester, umfassend ein Trägergehäuse (10) und zwei Tester (20) mit Berührungsspitzen (22), wobei das Trägergehäuse (10) adaptiert ist, die zwei Tester (20) in einer Testposition zu halten, in welcher die zwei Berührungsspitzen (22) sich im wesentlichen parallel zueinander erstrecken, wobei sie sich in Abstand entsprechend jenem befinden, der die Achsen der Steckerbuchsen einer Steckdose trennt, **dadurch gekennzeichnet, daß** das Trägergehäuse (10) adaptiert ist, um seitlich die zwei Tester (20) zu tragen, welche von einer Art mit Kabeln sind, die jeweils mit dem Trägergehäuse (10) durch ein Kabel (19) verbunden sind, wobei jeder Tester (20) mit Kabeln einen im wesentlichen zylindrischen Körper (21) aufweist, der adaptiert ist, durch das Trägergehäuse (10) zwischen einer seiner Seiten, nämlich der Rückseite, und wenigstens einem Flügel (14, 15) unterstützt zu werden, wobei sich der wenigstens ein Flügel (14, 15) seitlich von einer zentralen Rinne (13) erstreckt, mit welcher er versehen ist, wobei der im wesentlichen zylindrische Körper (21) von jedem Tester (20) mit Kabel mit einem Kragen (30) versehen ist, der adaptiert ist, in einer Testrinne (17), die in der rückwärtigen Fläche des Trägergehäuses (10) ausgebildet ist, für die axiale Positionierung in der Testposition dieses Testers (20) mit Kabel angeordnet zu sein, und adaptiert ist, um in einer sog. Lagerrinne (16) angeordnet zu werden, die von der Testrinne (17) unterschiedliche ist, die in der rückwärtigen Seite des Trägergehäuses (10) für die axiale Positionierung in der Lagerposition des Testers (20) mit Kabeln ausgebildet ist.

2. Tester nach Anspruch 1, **dadurch gekennzeichnet, daß** das Trägergehäuse (10) mit zwei Flügeln (14, 15) versehen ist, welche sich von der zentralen Rinne (13) der eine (14) am Ende, der andere (15) zentral erstrecken.

3. Tester nach Anspruch 1 oder 2, **dadurch gekennzeichnet, daß** das Trägergehäuse (10) mit zwei Flügeln (14, 15) versehen ist, die sich seitlich zu beiden Seiten der zentralen Rinne (13) erstrecken.

4. Tester nach Anspruch 3, **dadurch gekennzeichnet, daß** das Trägergehäuse (10) mit zwei Paaren von Flügeln (14, 15), einem Paar von Endflügeln (14) und einem Paar von zentralen Flügeln (15), versehen ist, wobei sich die Flügel (14, 15) desselben Paars seitlich zu beiden Seiten der zentralen Rinne (13) erstrecken.

5. Tester nach einem der Ansprüche 1 bis 4, **dadurch gekennzeichnet, daß** die Tester (20) Schutzhülsen (23) umfassen, um die Berührungsspitzen (22) zu schützen.

6. Tester nach Anspruch 5, **dadurch gekennzeichnet, daß** die Schutzhülsen (23) beweglich gegen elastische Rückführelemente zwischen einer ausgefahrenen Ruheposition, für welche sie sich zu dem Ende der Berührungsspitzen (22) erstrecken, und einer zurückgezogenen Betriebsposition festgelegt sind, in welcher sie wenigstens teilweise die Berührungsspitzen (22) freigeben.

7. Tester nach Anspruch 6, **dadurch gekennzeichnet, daß** die ausgefahrene Ruheposition der Schutzhülsen (23) unter der Steuerung eines Entriegelungsorgans (24), das für die Ermöglichung einer Freigabe geeignet ist, verriegelbar ist.

8. Tester nach Anspruch 7, **dadurch gekennzeichnet, daß** das Entriegelungsorgan (24) während des Ergreifens des Trägergehäuses (10) eingesetzt ist, wobei der Tester (20) mit Kabeln durch das Trägergehäuse (10) in seiner Testposition getragen ist.

9. Tester nach Anspruch 7 oder 8, **dadurch gekennzeichnet, daß** das Entriegelungsorgan (24) ein Hebel ist.

10. Tester nach Anspruch 7 oder 8, **dadurch gekennzeichnet, daß** das Entriegelungsorgan ein Druckknopf ist.

11. Trägergehäuse für elektrischen Tester, **dadurch gekennzeichnet, daß** es die Merkmale des Trägergehäuses (10) eines Tester nach einem der Ansprüche 1 bis 10 aufweist.
